(19) **Europäisches Patentamt / European Patent Office / Office européen des brevets**

(11) **EP 4 660 741 A1**

(12) **EUROPEAN PATENT APPLICATION**
published in accordance with Art. 153(4) EPC

(43) Date of publication:
**10.12.2025 Bulletin 2025/50**

(21) Application number: **24749603.7**

(22) Date of filing: **25.01.2024**

(51) International Patent Classification (IPC):
**G05D 23/20** (2006.01)

(52) Cooperative Patent Classification (CPC):
Y02D 10/00

(86) International application number:
**PCT/CN2024/074006**

(87) International publication number:
**WO 2024/160122 (08.08.2024 Gazette 2024/32)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **01.02.2023 CN 202310118291**

(71) Applicant: **BEIJING YOUZHUJU NETWORK TECHNOLOGY CO. LTD.**
**Beijing 101299 (CN)**

(72) Inventors:
• **CHEN, Yu**
  **Beijing 100028 (CN)**
• **SHEN, Xiangzhuang**
  **Beijing 100028 (CN)**
• **TANG, Junliang**
  **Beijing 100028 (CN)**
• **WANG, Jian**
  **Beijing 100028 (CN)**

(74) Representative: **Grünecker Patent- und Rechtsanwälte**
**PartG mbB**
**Leopoldstraße 4**
**80802 München (DE)**

(54) **METHOD AND APPARATUS FOR TEMPERATURE CONTROL, AND DEVICE AND STORAGE MEDIUM**

(57) A method, an apparatus, an electronic device (700) and a storage medium for temperature control are provided. A process (500) of temperature control includes: determining (510) predicted load information of a target device (120) based on historical operating information (201) associated with operation of the target device (120), the predicted load information (202) including at least a predicted load of the target device (120) at a first time point; determining (520) a first temperature indicator of a coolant predicted at the first time point based on the predicted load, historical temperature information (204) of the coolant, and historical operating information (203) of a coolant driving device (130), the coolant being configured to cool the target device (120), and the coolant driving device (130) being configured to drive a flow of the coolant; and determining (530) a first operating parameter of the coolant driving device (130) at the first time point based at least on the first temperature indicator. Thus, the accuracy and stability of temperature control may be improved.

500

| 510 |
| --- |
| DETERMINE PREDICTED LOAD INFORMATION OF A TARGET DEVICE BASED ON HISTORICAL OPERATING INFORMATION ASSOCIATED WITH OPERATION OF THE TARGET DEVICE |

| 520 |
| --- |
| DETERMINE A FIRST TEMPERATURE INDICATOR OF A COOLANT PREDICTED AT THE FIRST TIME POINT BASED ON THE PREDICTED LOAD, HISTORICAL TEMPERATURE INFORMATION OF THE COOLANT, AND HISTORICAL OPERATING INFORMATION OF A COOLANT DRIVING DEVICE |

| 530 |
| --- |
| DETERMINE A FIRST OPERATING PARAMETER OF THE COOLANT DRIVING DEVICE AT THE FIRST POINT OF TIME BASED AT LEAST ON THE FIRST TEMPERATURE INDICATOR |

FIG. 5

**Description**

This application claims priority to Chinese Patent Application No. 202310118291.3, filed on February 01, 2023, and entitled "METHOD, APPARATUS, DEVICE AND STORAGE MEDIUM FOR TEMPERATURE CONTROL", the entire content of which is incorporated herein by reference in its entirety.

**FIELD**

Example embodiments of the present disclosure generally relate to the field of computer, and more particularly, to a method, an apparatus, a device and a computer readable storage medium for temperature control.

**BACKGROUND**

With the development of big data technology of the Internet, servers in various data centers needs to store and process increasing amount of data, and switches also need to perform a large amount of data transmission. This leads to increasing power consumption and heat generation of devices such as servers and switches. In order to enable the normal operation of a data center, the data center is usually equipped with an air-cooling system or a liquid-cooling system, thereby achieving temperature control of devices such as servers and switches through air cooling or liquid cooling. By virtue of higher heat dissipation efficiency and lower energy consumption, liquid cooling is more widely applied.

**SUMMARY**

**In** a first aspect of the present disclosure, a method for temperature control is provided. The method includes: determining predicted load information of a target device based on historical operating information associated with operation of the target device, the predicted load information including at least a predicted load of the target device at a first time point; determining a first temperature indicator of a coolant predicted at the first time point based on the predicted load, historical temperature information of the coolant, and historical operating information of a coolant driving device, the coolant being configured to cool the target device, and the coolant driving device being configured to drive a flow of the coolant; and determining a first operating parameter of the coolant driving device at the first time point based at least on the first temperature indicator.

**In** a second aspect of the present disclosure, an apparatus for temperature control is provided. The apparatus includes: a load information determining module configured to determine predicted load information of a target device based on historical operating information associated with operation of the target device, the predicted load information including at least a predicted load of the target device at a first time point; a temperature indicator determining module configured to determine a first temperature indicator of a coolant predicted at the first time point based on the predicted load, historical temperature information of the coolant, and historical operating information of a coolant driving device, the coolant being configured to cool the target device, and the coolant driving device being configured to drive a flow of the coolant; and an operating parameter determining module configured to determine a first operating parameter of the coolant driving device at the first time point based at least on the first temperature indicator.

**In** a third aspect of the present disclosure, an electronic device is provided. The device includes: at least one processing unit; and at least one memory coupled to the at least one processing unit and storing instructions executed by the at least one processing unit. The instructions, when executed by the at least one processing unit, cause the device to perform the method according to the first aspect.

In a fourth aspect of the present disclosure, a computer readable storage medium is provided. The medium stores a computer program, which, when executed by a processor, implements the method according to the first aspect.

**It** should be understood that what is described in this Summary is not intended to identify key features or essential features of the implementations of the present disclosure, nor is it intended to limit the scope of the present disclosure. Other features disclosed herein will become easily understandable through the following description.

**BRIEF DESCRIPTION OF THE DRAWINGS**

The above and other features, advantages, and aspects of respective implementations of the present disclosure will become more apparent from the following detailed description with reference to the accompanying drawings. The same or similar reference numerals represent the same or similar elements throughout the figures, where:

FIG. 1 illustrates a schematic diagram of an example liquid cooling system in which embodiments of the present disclosure may be implemented;
FIG. 2 illustrates a schematic diagram of an example architecture of temperature control according to some embodiments of the present disclosure;

FIG. 3 illustrates a schematic diagram of an example of a non-linear autoregressive neural network according to some embodiments of the present disclosure;

FIG. 4 illustrates a schematic diagram of an example of a prediction control unit according to some embodiments of the present disclosure;

FIG. 5 illustrates a flowchart of a process for temperature control according to some embodiments of the present disclosure;

FIG. 6 illustrates a block diagram of an apparatus for temperature control according to some embodiments of the present disclosure; and

FIG. 7 illustrates a block diagram of an electronic device capable of implementing one or more embodiments of the present disclosure.

## DETAILED DESCRIPTION

It is to be understood that, before applying the technical solutions disclosed in respective embodiments of the present disclosure, the user should be informed of the type, scope of use, and use scenario of the personal information involved in the present disclosure in an appropriate manner in accordance with relevant laws and regulations, and user authorization should be obtained, wherein the user may include any type of rights holder, such as an individual, an enterprise, and a group.

For example, in response to receiving an active request from the user, prompt information is sent to the user to explicitly inform the user that the requested operation would acquire and use the user's personal information. Therefore, according to the prompt information, the user may decide on his/her own whether to provide the personal information to the software or hardware, such as electronic devices, applications, servers, or storage media that perform operations of the technical solutions of the present disclosure.

As an optional but non-limiting implementation, in response to receiving an active request from the user, the way of sending the prompt information to the user may, for example, include a pop-up window, and the prompt information may be presented in the form of text in the pop-up window. In addition, the pop-up window may also carry a select control for the user to choose to "agree" or "disagree" to provide the personal information to the electronic device.

It is to be understood that the above process of notifying and obtaining the user authorization is only illustrative and does not limit the implementations of the present disclosure. Other methods that satisfy relevant laws and regulations are also applicable to the implementations of the present disclosure.

It is to be understood that the data involved in this technical solution (including but not limited to the data itself, data acquisition, use, storage or deletion) should comply with the requirements of corresponding laws and regulations and relevant provisions.

The embodiments of the present disclosure will be described in more detail with reference to the accompanying drawings, in which some embodiments of the present disclosure have been illustrated. However, it should be understood that the present disclosure may be implemented in various manners, and thus should not be construed to be limited to embodiments disclosed herein. On the contrary, those embodiments are provided for the thorough and complete understanding of the present disclosure. It should be understood that the drawings and embodiments of the present disclosure are only used for illustration, rather than limiting the protection scope of the present disclosure.

It should be noted that the headings of any section/subsection provided herein are not limiting. Various embodiments are described throughout this specification, and any type of embodiment may be included under any section/subsection. Furthermore, embodiments described in any section/subsection may be combined in any manner with any other embodiments described in the same section/subsection and/or different sections/subsections.

As used herein, the term "comprise" and its variants are to be read as open terms that mean "include, but is not limited to." The term "based on" is to be read as "based at least in part on." The term "one embodiment" or "the embodiment" is to be read as "at least one embodiment." The term "some embodiments" is to be read as "at least some embodiments." Other definitions, explicit and implicit, might be further included below. The terms "first", "second" and the like may refer to different or identical objects. Other explicit and implicit definitions may also be included below.

As used herein, the term "model" may learn associations between corresponding inputs and outputs from training data, such that after training is completed a corresponding output may be generated for a given input. The generation of the model may be based on a machine learning technique. Depth learning is a machine learning algorithm that processes inputs and provides corresponding outputs by using a multi-tiered processing unit. A "model" may also be referred to herein as a "machine learning model", a "machine learning network", or a "network", which terms are used interchangeably herein. A model may in turn include various types of processing units or networks.

As used herein, the term "time point" may be expressed in any suitable time duration or unit. The time duration or unit may be, for example, minutes, hours, half-hours, days, etc.

As mentioned briefly above, in order to enable the normal operation of the data center, the data center is usually equipped with a liquid cooling system applying liquid cooling. Currently, the liquid cooling system mainly includes three types: immersion type, cold plate type and spray type, among which the immersion liquid cooling systems is most widely applied. The immersion liquid cooling system enable a heat-generating device to directly contact with the coolant by immersing the heat-generating device in the coolant, thereby performing heat exchange. For example, the immersion liquid cooling system with an internal integrated heat exchanger may efficiently meet a cooling requirement for self-circulation heat dissipation of devices such as servers or switches.

In a conventional temperature control solution for the immersion liquid cooling system, a temperature difference between the inlet and outlet liquids of the internal circulation is taken as a controlled parameter, to control the operating frequency of a circulating pump. This enables the liquid to flow at a certain speed and take away the heat of the heat-generating device, to ensure normal operation of electronic devices such as servers. However, since devices such as servers and switches have high power consumption, and the power consumption varies frequently with the business, the conventional temperature control solution has certain hysteresis and may not perform timely and effective temperature control. For example, the server temperature might be too high in a scenario with frequent business loads. For a further example, in a scenario with infrequent business loads, the server temperature might be too low. Insufficient cooling may affect the operation of various types of devices in the data center, while excessive cooling leads to waste of energy. Therefore, the conventional solution may not control the temperature in a timely and effective manner on the one hand, and on the other hand it may increase energy consumption, which is not conducive to energy conservation and emission reduction.

The problem of conventional temperature control solution is described above with the data center as an example, it should be understood that similar problems may exist in other scenarios where temperature control is required. In view of this, it is expected to provide a temperature control method to solve one or more of the above technical problems, as well as other potential problems.

Embodiments of the present disclosure provide a solution for temperature control. According to various embodiments of the present disclosure, predicted load information of a target device (used as a heat-generating device) is determined based on historical operating information associated with the operation of the target device. The predicted load information includes at least a predicted load of the target device at a time point of interest. A temperature indicator of the coolant at the time point is predicted based on the predicted load, historical temperature information of the coolant and historical operating information of a coolant driving device. The coolant is configured to cool the target device, and the coolant driving device is configured to drive the flow of the coolant. An operating parameter of the coolant driving device at the time point is determined based at least on the predicted temperature indicator. The operating parameter is configured to control the power, rotational speed, operating frequency and the like of the coolant driving device.

In embodiments of the present disclosure, with the predicted load information of the heat-generating device, the historical temperature information of the coolant, and the historical operating information of the coolant driving device, it is predicted how the coolant driving device should operate at a certain time point. That is, the operation of the coolant driving device may be controlled in conjunction with the prediction of the load condition of the heat-generating device. In this way, timely and effective temperature control may be advantageously achieved, thereby enhancing the stability and safety of the operation of the heat-generating device. In addition, it is possible to facilitate the coolant driving device to operate with an appropriate power consumption.

### *Example Liquid Cooling System*

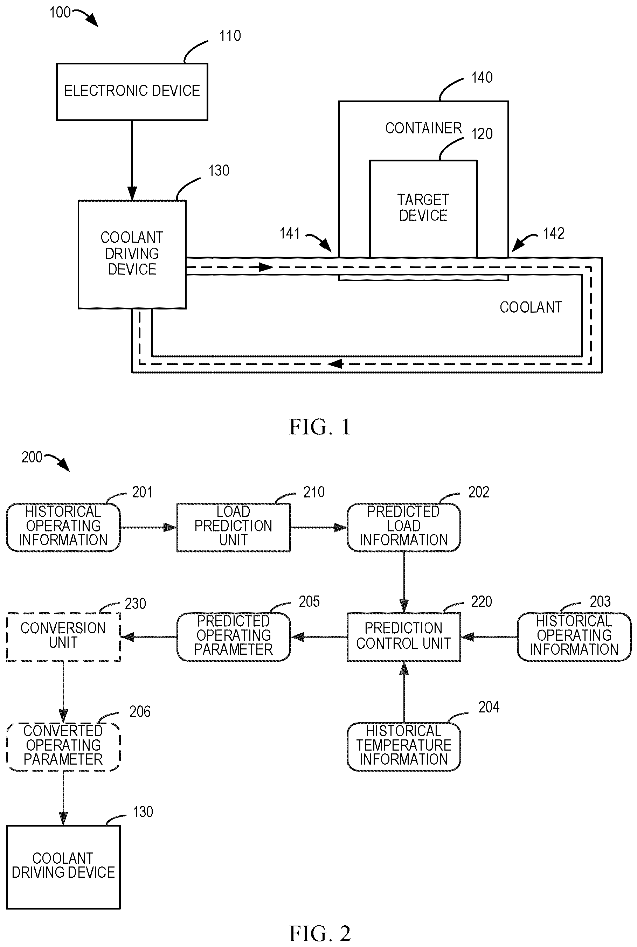

FIG. 1 shows a schematic diagram of an example liquid cooling system 100 in which embodiments of the present disclosure may be implemented. In the example liquid cooling system 100, a target device 120 may be any type of heat-generating device that needs to be cooled. In some embodiments, the target device 120 may be an electronic device in a data center. For example, the target device 120 may be an independent physical server, or may be a server cluster or a distributed system formed by a plurality of physical servers. The target device 120 may also be a device for other purposes in the data center, such as a switch, etc.

A container 140 includes a water inlet 141 and a water outlet 142. The target device 120 is placed inside the container 140. A coolant driving device 130 drives the coolant to flow into the container 140 from the water inlet 141, flow through the target device 120, and the flow out of the container 140 from the water outlet 142. Thus, the coolant may carry away the heat of the target device 120 to achieve temperature control of the target device 120. The coolant driving device 130 is configured to operate based on operating parameters to drive the flow of the coolant, so as to control the temperature of the target device 120. The coolant driving device 130 may be any suitable type of device capable of controlling the flow of liquid, such as a circulation pump. Although FIG. 1 shows only one coolant driving device, this is merely an example. Embodiments of the present disclosure may be applicable to a greater number of coolant driving devices.

The electronic device 110 predicts a predicted load of the target device 120 at a certain time point based on historical operating information associated with the target device 120, and then determines a temperature indicator at the time point based on the predicted load, historical temperature information of the coolant, and historical operating information of the coolant driving device 130. Then, the electronic device 110 determines an operating parameter of the coolant driving device 130 at the time point based on the temperature indicator.

To this end, the electronic device 110 and the coolant driving device 130 may have a function of performing data communication with each other. That is, a communication connection may be established between the electronic device 110 and the coolant driving device 130 through wireless communication or wired communication. The electronic device 110 may obtain the historical operating information of the coolant driving device 130 through the communication connection. Alternatively, the historical operating information of the coolant driving device 130 may be stored directly in the electronic device 110. On the other hand, the electronic device 110 may transmit the determined operating parameter to the coolant driving device 130 to control the operation of the coolant driving device 130.

The electronic device 110 and the target device 120 may have a function of performing data communication with each other. That is, a communication connection may be established between the electronic device 110 and the target device 120 through wireless communication or wired communication. The electronic device 110 may obtain the historical operating information associated with the target device 120 through the communication connection. In some examples, the target device 120 is further provided with a temperature acquisition apparatus. The target device 120 acquires temperature information of the coolant in real time and transmits it to the electronic device 110. In other examples, the temperature acquisition apparatus is provided in the electronic device 110. The electronic device 110 acquires temperature information of the coolant through the temperature acquisition apparatus and stores it in a memory for subsequent prediction of the temperature indicator at a certain time point with the historical temperature information.

The electronic device 110 may be any type of device having computing capabilities, including a terminal device or a server device. The terminal device may be any type of mobile terminal, fixed terminal, or portable terminal, including a mobile phone, a desktop computer, a laptop computer, a notebook computer, a netbook computer, a tablet computer, a media computer, a multimedia tablet, or any combination thereof, including accessories and peripherals of these devices, or any combination thereof. The server device may include, for example, a computing system and a server.

It should be understood that the structure and function of the liquid cooling system 100 are described for example purposes only and are not intended to imply any limitation on the scope of the disclosure. For example, although the electronic device 110 is shown separately from the coolant driving device 130, in some embodiments, the electronic device 110 may be implemented in the coolant driving device 130, e.g., as a controller therein. In addition, the manner in which the electronic device 110 obtains historical operating information and historical operating information described above is also an example, and is not intended to limit the scope of the present disclosure. In embodiments of the present disclosure, the electronic device 110 may obtain the data required for temperature control in any suitable manner.

Some example embodiments of the present disclosure will be described below with further reference to the accompanying drawings.

### *Overall Architecture of Temperature Control*

FIG. 2 illustrates a schematic diagram of an example architecture 200 of temperature control according to some embodiments of the present disclosure. The architecture 200 generally includes a load prediction unit 210 and a prediction control unit 220. In some embodiments, the architecture 200 may also include a conversion unit 230. These units in the architecture 200 and other units not shown may be implemented in the electronic device 110.

The load prediction unit 210 is configured to predict load information of the target device 120 based on historical operating information 201 associated with operation of the target device 120. In other words, the load prediction unit 210 determines the predicted load information 202 of the target device 120 based on the historical operating information 201. The predicted load information 202 at least includes the predicted load of the target device 120 at a time point t (also referred to as a first time point). The time point t may be a current time point or any future time point.

In some embodiments, the predicted load information 202 determined by the load prediction unit 210 may include respective predicted loads of the target device 120 at a plurality of time points. The plurality of time points may include the time point t and one or more time points after the time point $t$.

In some embodiments, the historical operating information 201 may include a historical load of the target device 120 over a time period before the time point t. The load prediction unit 210 may predict the predicted load information 202 of the target device 120 at the time point t based on the historical load. In other embodiments, in order to make the predicted load information 202 more accurate, the historical operating information 201 may include, in addition to the historical load of the target device 120 in a time period before the time point $t$, an environmental factor experienced by the target device 120 in the time period before the time point t. The environmental factor is an auxiliary factor for predicting the load, and may include factors such as ambient temperature, season, humidity, etc. Various information items in the historical operating information 201 (such as each historical load, each environmental factor) may have timestamps to identify corresponding historical time points.

The same history period or different history periods may be considered for the historical load and environmental factors. For example, the historical load may include a load of the target device 120 over a first historical time period before the time point t, and the environmental factor may include an environmental factor experienced by the target device 120 over a second historical time period before the time point t. The first historical time period may be the same or different than the second historical time period.

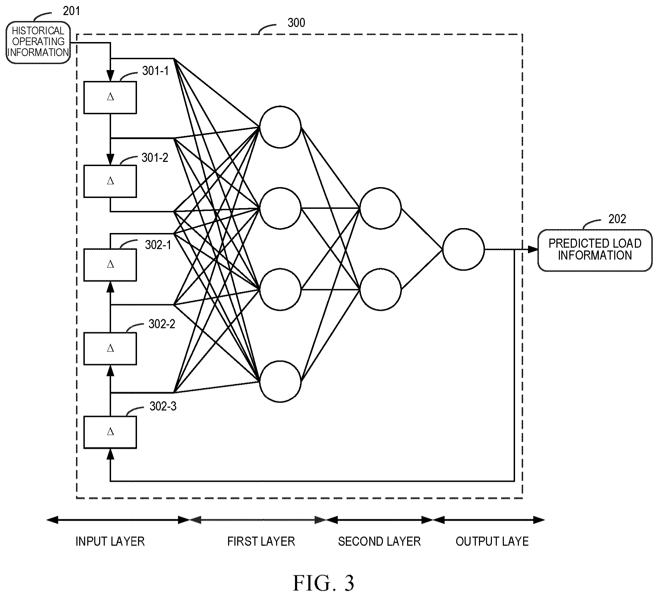

The load of the target device 120 may be predicted based on the historical operating information 201 based on any suitable algorithm. Since the historical operating information 201 is time series data, in some embodiments, the load prediction unit 210 may determine the predicted load information 202 using a model or neural network involving a time series. Examples of models or neural networks involving time series may include, without limitation, recurrent neural networks (RNNs), time-delayed neural networks (TDNNs), and non-linear autoregressive (NARX) neural networks, among others. A NARX neural network will be taken as example of determining the predicted load information 202 based on the historical operating information 201. FIG. 3 illustrates a schematic diagram of a NARX neural network 300 according to some embodiments of the disclosure. NARX 300 may be implemented in the load prediction unit 210.

As shown in FIG. 3, the trained NARX neural network 300 determines the predicted load information 202 based on the historical operating information 201. In this example, the NARX neural network 300 includes an input layer, a first layer, a second layer, and an output layer, whereas it should be understood that this is merely an example and is not intended to limit the scope of the present disclosure. In this example, the historical operating information 201 includes historical loads and historical environmental factors. In particular, to predict the load at the time point t, historical environmental factors 301-1 and 301-2 experienced by the target device 120 over some historical time period before the time point t as well as historical loads 302-1, 302-2, and 302-3 of the target device 120 over some historical time period before t serve as inputs to the NARX neural network 300. The predicted load at t of the target device 120 is then obtained as at least a portion of the predicted load information 202 through processing of the first, second, and output layers of the NARX neural network 300.

As an example, the prediction of the load by the NARX neural network 300 may be represented by:

$$y(t) = f(x(t-1), \ldots, x(t-d_x), y(t-1), y(t-2), \ldots, y(t-d_y)) \qquad (1)$$

wherein x denotes an environmental factor, y denotes a load, t denotes the time point *t*, t - 1, t - 2, t - $d_x$, t - $d_y$ denote time points within a historical time period before the time point t, x(t - 1),..., x(t - $d_x$)denotes an environmental factor corresponding to the time point t - 1, t - 2, t - $d_x$, t - $d_y$, and y(t - 1), yet - 2), ... ., y(t - $d_y$) denotes a historical load corresponding to the time point t - 1, t - 2, t - $d_x$, t - $d_y$ (also referred to as an input delay) and is related to the duration of the historical time period considered for the environmental factor, and $d_y$ denotes an output delay (also referred to as an output delay) and is related to the duration of the historical time period considered for the load.

Examples of predicting the load at t have been described above with reference to FIG. 3 and Formula (1). The prediction of the load at other time point (e.g., time point t + 1, time point t + 2) is similar. In addition, the reference to FIG. 3 and Formula (1) is merely an example and is not intended to limit the scope of the present disclosure. In embodiments of the present disclosure, the load prediction unit 210 may determine the predicted load information 202 of the target device 120 using any known or future developed model or neural network.

With reference to FIG 2 still, the load prediction information 202 is provided to the prediction control unit 220. The prediction control unit 220 also obtains historical temperature information 204 of the coolant. The historical temperature information 204 of the coolant may include a temperature indicator for the coolant at one or more time points before t. In embodiments of the present disclosure, the temperature indicator may include any data capable of indicating the coolant temperature. In some embodiments, the temperature indicator may include the temperature of the coolant at a location on its flow path (e.g., the water inlet 141 or the water outlet 142). Alternatively or additionally, in some embodiments, the temperature indicator may include an average temperature of the coolant at a plurality of locations. Alternatively or additionally, in some embodiments, the temperature indicator may include a difference, also referred to simply as a temperature difference, between the temperature of the coolant at the first location and the temperature at the second location of the flow path. For example, the temperature indicator may include a temperature difference of the coolant between the water inlet 141 and the water outlet 142. By using such a temperature difference, heat dissipated by cooling the target device 120 may be reflected more realistically, thereby facilitating more accurate temperature control.

The prediction control unit 220 also obtains historical operating information 203 of the coolant driving device 130. The historical operating information 203 may include operating parameters of the coolant driving device 130 at one or more time points before t. In embodiments of the present disclosure, the operating parameters may include any data related to the driving of the coolant. For example, the operating parameters may include the operating power, operating frequency, and rotational speed and so on of the cooling driving device 130 (e.g., circulation pump).

The historical operation information 203 and the historical temperature information 204 may also have a timestamp to identify a corresponding historical time point. The prediction control unit 220 may predict the operating parameters of the coolant driving device 130 at t based on the load prediction information 202, the historical operation information 203, and the historical temperature information 204. That is, the prediction control unit 220 determines a predicted operating parameter 205. It is understandable that, in order to make a prediction result of the prediction control unit 220 more accurate, the historical operating parameter included in the historical operating information 203 and the historical temperature indicator of the historical temperature information 204 are values corresponding to the same one or more time points before the time point t.

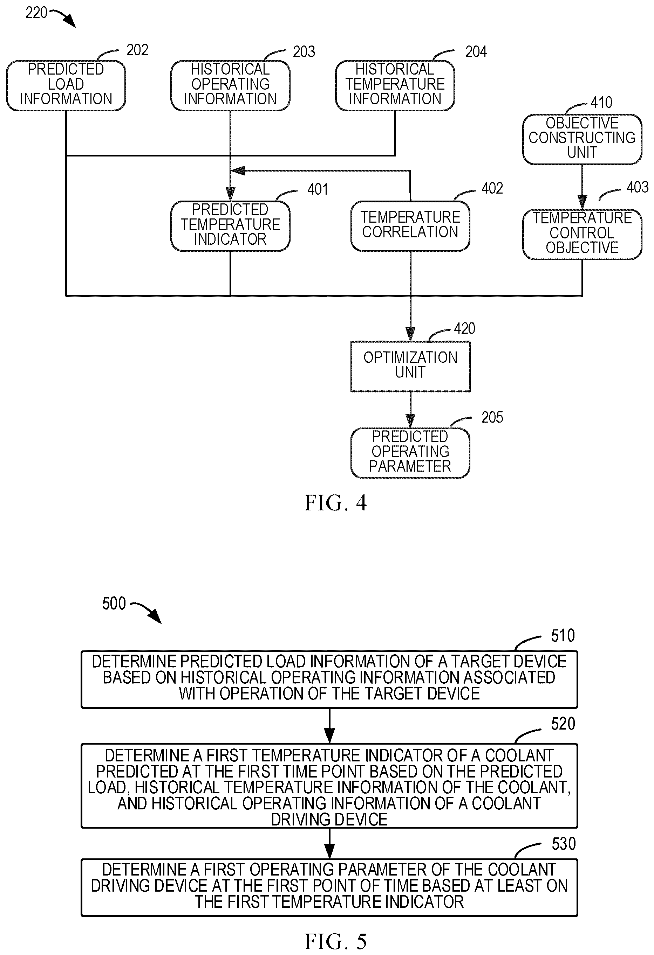

In particular, the prediction control unit 220 first determines a predicted temperature indicator, also referred to as a first temperature indicator, of the coolant at the time point t. In order to predict the temperature indicator at the time point t, the prediction control unit 220 may be based on the predicted load at the time point t, the historical temperature information of the coolant, and the historical operating information of the coolant driving device 130. In some embodiments, a neural network may be utilized to predict the temperature indicator at the time point t based on the predicted load, the historical temperature information, and the historical operating information. In some embodiments, in order to predict the temperature indicator at the time point t, a correlation specific to the coolant temperature, also referred to as a temperature correlation, may additionally be considered. The temperature correlation indicates the dependence of the coolant temperature indicator on the operating parameters of the coolant driving device 130 and the load of the target device 120. For example, the temperature correlation may indicate the relationship of the temperature difference at the time point t with the operating parameters and load at a time point before the time point t. The temperature correlation will be described in detail below with reference to FIG. 4.

Then, the prediction control unit 220 determines an operating parameter of the coolant driving device 130 at the time point t, i.e., the predicted operating parameter 205, based on the predicted temperature indicator at t. The prediction control unit 220 may predict the operating parameters using any suitable algorithm. In some embodiments, the operating parameters may be predicted using trained machine learning models. Alternatively, in some embodiments, a relationship between the temperature indicator and the operating parameter may be constructed based on the historical temperature information and the historical operating information, for example, a relationship between a temperature difference and a rotation speed may be constructed. The value of the operating parameter at the time point t may then be predicted based on the relationship. In some embodiments, the operating parameter may additionally be predicted in view of the temperature correlation mentioned above. Such an embodiment will be described below with reference to FIG. 4.

With reference to FIG 2 still, in some embodiments, the prediction control unit 220 may provide the predicted operating parameter 205 directly to the coolant driving device 130. Alternatively, in some embodiments, the predicted operating parameter 205 determined by the prediction control unit 220 may have a different dimension than the operating parameter actually used by the coolant driving device 130. To this end, as shown in FIG. 2, the architecture 200 may further include a conversion unit 230. The converted operating parameters 206 output by the conversion unit 230 may be directly received by the coolant driving device 130 and operated according to the converted operating parameter 206 to drive the flow of the coolant.

An example architecture 200 for temperature control has been described above. It should be understood that the division of units and their functionality in the architecture 200 is merely an example and is not intended to limit the scope of the present disclosure.

### *Prediction of Temperature and Operating Parameter*

As briefly mentioned above with reference to FIG. 2, in some embodiments, in order to predict the temperature indicator and/or the operating parameter at the time point t, the prediction control unit 220 may take the temperature correlation into consideration. Such an example embodiment is described below with reference to FIG. 4. FIG. 4 illustrates a schematic diagram of an example of the prediction control unit 220 according to some embodiments of the disclosure.

As mentioned above with reference to FIG 2, a temperature correlation 402 indicates the dependence of the temperature indicator of the coolant on the operating parameter of the coolant driving device 130 and the load of the target device 120. The temperature correlation 402 may be determined by analyzing the relationship between the historical temperature information of the coolant, the historical operating information of the coolant driving device 130, and the historical load of the target device 120.

In some embodiments, the temperature correlation 402 may be determined offline based on the historical information described above. In such embodiments, the electronic device 101 may read the locally-stored temperature correlation 402, or receive already-determined temperature correlation 402 from other suitable device.

In some embodiments, the temperature correlation 402 may be determined by the electronic device 110 online. The electronic device 110 may dynamically update the temperature correlation 402 at regular intervals (e.g., periodically) based on the temperature information, the operating information, and the load over a previous time period. In such an embodiment, such a dynamically updated temperature correlation 402 may more truly reflect relationships between various components of the liquid cooling system (e.g., the target device 120, the coolant driving device 130).

In particular, the prediction control unit 220 may determine respective historical temperature indicators of the coolant at a plurality of historical time points before t, based on the historical temperature information 204. The prediction control unit 220 may determine respective historical operating parameters of the coolant driving device 130 at a plurality of historical time points based on the historical operating information 203. In addition, based on a corresponding historical temperature indicator, a corresponding historical operating parameter, and a corresponding historical load of the target device 120 at a plurality of historical time points, the prediction control unit 220 may determine a corresponding parameter in the correlation, so as to obtain the temperature correlation 402. For example, the prediction control unit 220 may determine the corresponding parameters in the correlation using any suitable algorithm, such as a least mean square (LMS) algorithm, a recursive least squares (RLS) algorithm, and a gradient descent algorithm.

Taking a temperature difference as an example of a temperature indicator, and taking power as an example of an operating parameter, the temperature correlation 402 may be represented by the following formula:

$$\hat{T}_{diff}(t0) = a\left[\hat{T}_{diff}(t0-1) + \frac{\Delta t}{C}\left[P(t0-1) - U\hat{T}_{diff}(t0-1)\right]\right] + \hat{y}(t0) \qquad (2)$$

$\hat{T}_{diff}(t0)$ is a temperature difference of the coolant at the water inlet 141 and the water outlet 142 of the container 140 at a time point $t0$, $\hat{T}_{diff}(t0-1)$ is a temperature difference at a time point $t0-1$, and $\Delta t$ is related to a time span between $t$ and $t-1$, i.e. an actual time difference between $t-1$ and $t$, P represents the power of the coolant driving device 130, $\hat{y}(t0)$ represents the load of the target device driving device 120 at a time point $t0$, and a, C, U are parameters of the formula.

The parameters a, C, U may be determined using a suitable algorithm, such as the RLS algorithm based on the historical load, historical power and historical temperature difference. Specifically, when determining the temperature correlation 402, a plurality of historical time points may be respectively set as $t0$, so that a plurality of formulas including the parameters a, C, U may be obtained based on Formula (2). The values of the parameters a, C, U may then be determined using the RLS algorithm. In this manner, the temperature correlation 402 described above is determined. While the temperature correlation has been described above with the temperature difference and power as examples, this is merely an example. For other types of temperature indicators and operating parameters, the temperature correlation may be determined in a similar manner.

After obtaining the temperature correlation 402, the prediction control unit 220 may determine, according to the temperature correlation 402, the predicted temperature indicator 401 of the coolant at the time point t based on the load prediction information 202, the historical operating information 203, and the historical temperature information 204. Specifically, the historical temperature information 204 may include a temperature indicator of the coolant at the time point t - 1, the historical operating information 203 may include an operating parameter of the coolant driving device 130 at t-1, and the predicted load information 202 may include a predicted load at the time point t. The predicted temperature indicator 401 may be obtained based on the temperature indicator at the time point t - 1, the operating parameter at the time point t - 1, and the predicted load at t according to the temperature correlation.

In some embodiments, the predicted temperature indicator 401 of the coolant at the time point t determined by the prediction control unit 220 includes the difference between the temperature of the coolant at a first location and the temperature at a second location of the flow path. For example, the difference between the temperature of the coolant at the water inlet 141 of the container 140 and the temperature at the water outlet 142 of the container 140 may be included. In the example described above, the time point $t$ may be used as $t0$ in Formula (2). The temperature difference at the time point $t$ may be predicted by applying the temperature difference at the time point $t - 1$, the power at the time point $t - 1$, and the predicted load at the time point t to Formula (2).

An example process for determining the predicted temperature indicator 401 has been described above. An example process for predicting the operating parameter is to be described below with reference to FIG 4 still. In some embodiments, the prediction of the operating parameter may be implemented using a model predictive control (MPC) algorithm. With the MPC algorithm, a temperature control plan may be generated based on a predicted load or the like within a predetermined time range, and a first operating parameter that meets a temperature control objective may be applied to the coolant driving device 130.

To this end, the prediction control unit 220 may further include an objective construction unit 410 and an optimization unit 420. In particular, the objective construction unit 410 is configured to construct a temperature control objective 403 for the target device 120. In the liquid cooling system, a basic target of temperature control is that a temperature indicator is as close as possible to a preset reference temperature indicator. For example, the desired temperature difference may be as close to the reference temperature difference as possible. The reference temperature indicator may be an optimal temperature indicator to ensure normal operation of the target device 120, or a corresponding target temperature indicator when the coolant driving device 130 maintains less power consumption. To this end, the temperature control objective 403 includes at least a temperature term for reducing the difference between the respective predicted temperature indicator and the reference temperature indicator at a plurality of time points. These time points include the time point $t$ and one or more time points after the time point $t$.

Further, an optional target of temperature control is to achieve the desired temperature control effect with as low power consumption as possible. Accordingly, in some embodiments, the temperature control objective 403 may additionally include a power consumption term for reducing power consumption of the coolant driving device 130 at the plurality of time points described above. In this way, a supply greater than demand may be avoided, so as to reduce the power consumption of the liquid cooling system. Combining these two goals facilitates a balance between supply and demand and enhances the stability and safety of the liquid cooling system in the event of a failure.

Taking the temperature difference as an example of the temperature indicator, the temperature control objective 403 may be represented by the following formula:

$$J(t) = \sum_{k=0}^{N} \left\| \widehat{T_{diff}}(t+k) - T_d \right\|_Q^2 + \sum_{k=0}^{N} \| \Delta P(t+k-1) \|_R^2 \qquad (3)$$

where J(t) represents a temperature control objective for the time point t, which may also be considered as a loss function; $\sum_{k=0}^{N} \left\| \widehat{T_{diff}}(t+k) - T_d \right\|_Q^2$ is a temperature item; $\sum_{k=0}^{N} \| \Delta P(t+k-1) \|_R^2$ represents a power consumption item; Q, R, N, $T_d$ represent a state weighted coefficient, an input weighted coefficient, a time window, and a reference temperature indicator (in this example, a reference temperature difference) respectively, and N is an integer greater than 1. $\Delta P$ may represent the difference between the predicted power of the coolant driving device 130 at a time point considered and the reference power, or represent the difference between the predicted powers at neighboring time points.

The optimization unit 420 extracts corresponding predicted loads of the target device 120 at the plurality of time points from the predicted load information 202. The optimization unit 420 then determines a parameter value of the predicted operating parameter 205 based on the corresponding predicted loads, the predicted temperature indicator 401, and the temperature correlation 402 based on the temperature control objective 403. The optimization unit 420 may determine the parameter value of the operating parameter at the time point t by minimizing the temperature control objective 403. For example, by minimizing J(t), powers P at the plurality of time points as described above may be obtained, wherein the value of P corresponding to t may be used as a determined operating parameter to control the coolant driving device 130.

In some embodiments, the optimization unit 420 may additionally consider constraints when minimizing the temperature control objective 403. That is, the optimization unit 430 may minimize the temperature control objective 493 under one or more constraints. As an example, the constraint may include a value range of the predicted temperature indicator, that is, the temperature indicator at each time point should not exceed an expected value range. For example, the constraint may include an upper limit and a lower limit for the temperature difference. By considering a value range of the temperature indicator, abnormal operation caused by excessively high temperature of the target device 120 may be avoided.

Alternatively or additionally, the constraint may include a value range of values of respective operational parameters of the coolant driving device 130 at the plurality of time points described above. For example, the constraint may include the upper and lower limits of the power of the coolant driving device 130. By considering the value range of the operating parameter, excessive power consumption of the coolant driving device 130 may be avoided.

Still taking a temperature difference as an example of a temperature indicator and taking power as an example of an operating parameter, a constraint regarding a value range of a predicted temperature indicator may be represented as Formula (6), and a constraint regarding a value range of an operating parameter may be represented as Formula (7):

$$\widehat{T}_{diff}(t) = a\left[\widehat{T}_{diff}(t-1) + \frac{\Delta t}{C}\left[P(t-1) - U\widehat{T}_{diff}(t-1)\right]\right] + \hat{b}(t) \qquad (4)$$

$$\overline{T}_{diff}(t) = a\left[\overline{T}_{diff}(t-1) + \frac{\Delta t}{C}\left[P(t-1) - U\overline{T}_{diff}(t-1)\right]\right] + \overline{b}(t) \qquad (5)$$

$$T_{diff}^{min} \leq \overline{T}_{diff}(t+k) \leq T_{diff}^{max} \qquad (6)$$

$$P^{min} \leq P(t+k-1) \leq P^{max} \qquad (7)$$

Where $T_{diff}^{min}$ denotes the minimum value of the temperature difference, $T_{diff}^{max}$ denotes the maximum value of the temperature difference, $P^{min}$ denotes the minimum value of the power, and $P^{max}$ denotes the maximum value of the power.

**In** such an example, the temperature control objective of Formula (3) is minimized under the constraints represented by Formulas (6) and (7), thereby determining the predicted value of the operating parameter at the time point t.

The prediction of the operating parameter at the time point t has been described above with reference to FIG. 2 to FIG. 4. At the time point t, the predicted value of the operating parameter is applied to the coolant driving device 130. That is, at the time point t, the coolant driving device 130 may operate in accordance with the determined operating parameter, and then the temperature control proceeds to the next stage. Data such as the load of the target device 120 at the time point t, the temperature indicator of the coolant at t will be used as historical information for determining the operating parameter at a time point t + 1. Thus, a circulation process of feedback, adjustment and control is realized for the temperature control of the liquid cooling system. This is a self-learning MPC model based on services and temperatures, to control the temperature and ensure heat dissipation when the services change frequently.

In a conventional temperature control system based on a model algorithm, environmental information is embedded in temperature control in the form of mathematical modeling, but instability and model errors remain difficult problems to solve. As one of the highly efficient algorithms in the model algorithms, the efficiency of the MPC is directly proportional to the accuracy of the modeling. However, in the case of a complex environment and various influence factors, the modeling accuracy decreases and the efficiency of MPC is greatly reduced. Meanwhile, the model algorithm has poor generalization, and each model needs to be specially customized according to an environment.

In contrast, in the embodiments of the present disclosure described above, a predicted load is introduced into the MPC model, which is derived based on an analysis of various data. In this way, stability and robustness are increased compared to conventional solutions, as well as energy saving performance.

Further, the machine learning model has a good performance in building a multi-region model that is non-linear, non-stable and time varying, and at the same time, the performance in processing a large amount of data and region data is also widely recognized. The machine learning algorithm may improve the model and optimize the control logic by learning historical data, and the machine learning may also predict the heat dissipation demand of IT equipment through complex data analysis. As previously described, in some embodiments, the machine learning model may be combined with MPC to achieve more accurate and efficient temperature control. For example, a neural networks is configured to analyze and predict the load of the target device, and then the MPC algorithm manipulates adjustments based on the predicted load, etc. In the combination of the machine learning model and MPC, on the one hand, the MPC model may assist the machine learning model in mining and learning information in data, and on the other hand, analysis of various data and prediction of loads may be completed by the machine learning model, and then be manipulated by the MPC model.

### *Example Processes*

FIG. 5 illustrates a flow diagram of a process 500 for temperature control according to some embodiments of the present disclosure. The process 500 may be implemented at the electronic device 110. The process 500 is described below with reference to FIG. 1 and FIG. 2.

At block 510, the electronic device 110 determines predicted load information 202 of a target device 120 based on historical operating information 201 associated with operation of the target device 120. The predicted load information 202 includes at least a predicted load of the target device 120 at a first time point.

In some embodiments, the historical operating information includes a load of the target device 120 over a first historical time period before the first time point, and environmental factors to which the target device 120 is subject over a second historical time period before the first time point.

At block 520, the electronic device 110 determines a first temperature indicator of a coolant predicted at the first time point based on the predicted load, historical temperature information 204 of the coolant, and historical operating information 203 of a coolant driving device 130. The coolant is configured to cool the target device 120, and the coolant driving device 130 is configured to drive a flow of the coolant.

In some embodiments, the historical temperature information 204 includes a second temperature indicator of the coolant at a second time point, and the historical operating information 203 includes a second operating parameter of the coolant driving device 130 at the second time point, the second time point is before the first time point. Determining, by electronic device 110, the first temperature indicator includes: obtaining a correlation for a temperature of the coolant, the correlation indicating a dependence of a temperature indicator of the coolant on an operating parameter of the coolant driving device 130 and a load of the target device 120. The electronic device 110 predicts the first temperature indicator according to the correlation and based on the predicted load, the second temperature indicator, and the second operating parameter.

In some embodiments, to obtain the correlation, the electronic device 110 determines respective historical temperature indicators of the coolant at a plurality of historical time points before the first time point based on the historical temperature information 204. The electronic device 110 determines respective historical operating parameters of the coolant driving device 130 at the plurality of historical time points based on the historical operating information. The electronic device 110 determines the correlation based on the respective historical temperature indicators, the respective historical operating parameters 203, and respective historical loads of the target device 120 at the plurality of historical time points.

In some embodiments, the first temperature indicator includes a difference between a temperature of the coolant at a first location and a temperature at a second location in a flow path.

At block 530, the prediction control unit 220 in the electronic device 110 determines a first operating parameter of the coolant driving device 130 at the first time point based at least on the first temperature indicator.

In some embodiments, the predicted load information includes respective predicted loads of the target device at a plurality of time points, the plurality of time points includes at least the first time point and a third time point after the first time point. In order to determine the first operating parameter, the prediction control unit 220 constructs a temperature control objective. The temperature control objective is configured to at least reduce a difference between a reference temperature indicator and respective predicted temperature indicators at the plurality of time points. The prediction control unit 220 determines a parameter value of the first operating parameter according to the temperature control objective and based on the respective predicted loads, the first temperature indicator and the correlation for the temperature of the coolant. The correlation indicates the dependence of a temperature indicator of the coolant on an operating parameter of the coolant driving device 130 and a load of the target device.

In some embodiments, the temperature control objective is further configured to reduce power consumption of the coolant driving device 130 at the plurality of time points.

In some embodiments, determining the parameter value of the first operating parameter is further based on at least one of: a range of values of the respective predicted temperature indicators, and a range of values of respective operating parameters of the coolant driving device 130 at the plurality of time points.

### *Example Apparatus and Device*

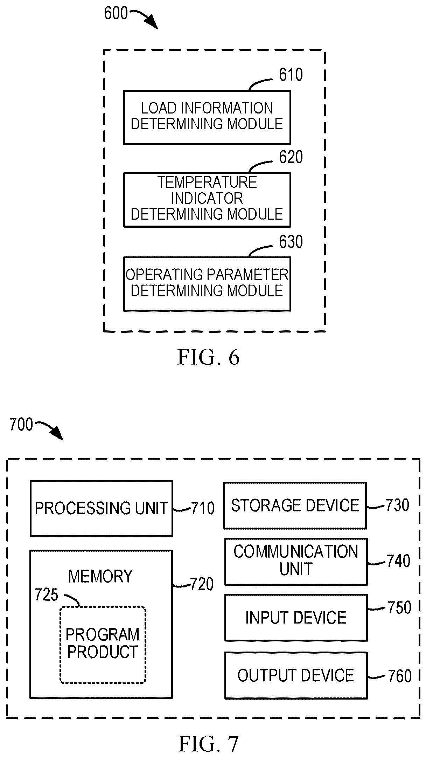

FIG. 6 shows a schematic block diagram of an apparatus 600 for temperature control according to some embodiments of the present disclosure. The apparatus 600 may be implemented as or included in the electronic device 110. The various modules/components in the apparatus 600 may be implemented by hardware, software, firmware, or any combination thereof.

As depicted, the apparatus 600 includes a load information determining module 610 configured to determine predicted load information of a target device based on historical operating information associated with operation of the target device, the predicted load information including at least a predicted load of the target device at a first time point. The apparatus 600 further includes a temperature indicator determining module 620 configured to determine a first temperature indicator of a coolant predicted at the first time point based on the predicted load, historical temperature information of the coolant, and historical operating information of a coolant driving device, the coolant being configured to cool the target device, and the coolant driving device being configured to drive a flow of the coolant. The apparatus 600 further includes an operating parameter determining module 630 configured to determine a first operating parameter of the coolant driving device at the first time point based at least on the first temperature indicator.

In some embodiments, the historical temperature information includes a second temperature indicator of the coolant at a second time point, and the historical operating information includes a second operating parameter of the coolant driving device at the second time point, the second time point is before the first time point. The temperature indicator determining module 620 includes: a correlation obtaining module configured to obtain a correlation for a temperature of the coolant, the correlation indicating a dependence of a temperature indicator of the coolant on an operating parameter of the coolant driving device and a load of the target device; and a temperature indicator predicting module configured to predict the first temperature indicator according to the correlation based on the predicted load, the second temperature indicator, and the second operating parameter.

In some embodiments, the correlation obtaining module includes: a historical temperature indicator determining module configured to determine respective historical temperature indicators of the coolant at a plurality of historical time points before the first time point based on the historical temperature information; a historical operating parameter determining module configured to determine respective historical operating parameters of the coolant driving device at the plurality of historical time points based on the historical operating information; and a correlation determining module configured to determine the correlation based on the respective historical temperature indicators, the respective historical operating parameters, and respective historical loads of the target device at the plurality of historical time points.

In some embodiments, the first temperature indicator includes a difference between a temperature of the coolant at a first location and a temperature at a second location of a flow path.

In some embodiments, the predicted load information includes respective predicted loads of the target device at a plurality of time points, the plurality of time points including at least the first time point and a third time point after the first time point. The operating parameter determining module 630 includes: a temperature control objective constructing module configured to construct a temperature control objective for at least reducing a difference between a reference temperature indicator and respective predicted temperature indicators at the plurality of time points; and a parameter value determining module configured to determine a parameter value of the first operating parameter according to the temperature control objective based on the respective predicted loads, the first temperature indicator and the correlation for the temperature of the coolant, the correlation indicating the dependence of a temperature indicator of the coolant on an operating parameter of the coolant driving device and a load of the target device.

**In** some embodiments, the temperature control objective is further configured to reduce power consumption of the coolant driving device at the plurality of time points.

**In** some embodiments, determining the parameter value of the first operating parameter is further based on at least one of: a range of values of the respective predicted temperature indicators, and a range of values of respective operating parameters of the coolant driving device 130 at the plurality of time points.

**In** some embodiments, the historical operating information includes a load of the target device over a first historical time period before the first time point, and environmental factors to which the target device is subject over a second historical time period before the first time point.

FIG. 7 shows a block diagram of an electronic device 700 in which one or more embodiments of the present disclosure may be implemented. It should be understood that the electronic device 700 illustrated in FIG. 7 is merely an example and should not constitute any limitation on the functionality and scope of the embodiments described herein. The electronic device 700 shown in FIG. 7 may be configured to implement the electronic device 110 in FIG. 1.

As shown in FIG. 7, the electronic device 700 is in the form of a general purpose computing device. Components of the electronic device 700 may include, but are not limited to, one or more processors or processing units 710, a memory 720, a storage device 730, one or more communication units 740, one or more input devices 750, and one or more output devices 760. The processing unit 710 may be a physical or virtual processor and may execute various processing based on the programs stored in the memory 720. In a multi-processor system, a plurality of processing units executes computer-executable instructions in parallel to enhance parallel processing capability of the electronic device 700.

The electronic device 700 usually includes a plurality of computer storage mediums. Such mediums may be any attainable medium accessible by the electronic device 700, including but not limited to, a volatile and non-volatile medium, a removable and non-removable medium. The memory 720 may be a volatile memory (e.g., a register, a cache, a Random Access Memory (RAM)), a non-volatile memory (such as, a Read-Only Memory (ROM), an Electrically Erasable Programmable Read-Only Memory (EEPROM), flash), or any combination thereof. The storage device 730 may be a removable or non-removable medium, and may include a machine-readable medium (e.g., a memory, a flash drive, a magnetic disk) or any other medium, which may be used for storing information and/or data (e.g., training data for training) and be accessed within the computing device 700.

The electronic device 700 may further include additional removable/non-removable, volatile/non-volatile storage mediums. Although not shown in FIG. 7, there may be provided a disk drive for reading from or writing into a removable and non-volatile disk (e.g., "floppy disk") and an optical disc drive for reading from or writing into a removable and non-volatile optical disc. In such cases, each drive may be connected to a bus (not shown) via one or more data medium interfaces. The memory 720 may include a computer program product 725 having one or more program modules, and these program modules are configured for performing various methods or acts of various implementations of the present disclosure.

The communication unit 740 implements communication with another computing device via a communication medium. Additionally, functions of components of the electronic device 700 may be realized by a single computing cluster or a plurality of computing machines, and these computing machines may communicate through communication connections. Therefore, the electronic device 700 may operate in a networked environment using a logic connection to one or more other servers, a Personal Computer (PC) or a further general network node.

The input device 750 may be one or more various input devices, such as a mouse, a keyboard, a trackball, a voice-input device, and the like. The output device 760 may be one or more output devices, e.g., a display, a loudspeaker, a printer, and so on. The electronic device 700 may also communicate through the communication unit 740 with one or more external devices (not shown) as required, where the external device, e.g., a storage device, a display device, and so on, communicates with one or more devices that enable users to interact with the electronic device 700, or with any device (such as a network card, a modem, and the like) that enable the electronic device 700 to communicate with one or more other computing devices. Such communication may be executed via an Input/Output (I/O) interface (not shown).

According to the example implementations of the present disclosure, a computer-readable storage medium is provided, on which computer-executable instructions are stored, wherein the computer-executable instructions are executed by a processor to implement the method described above. According to the example implementations of the present disclosure, a computer program product is further provided, which is tangibly stored on a non-transient computer-readable medium and includes computer-executable instructions, which are executed by a processor to implement the method described above.

Aspects of the present disclosure are described herein with reference to flowchart illustrations and/or block diagrams of methods, apparatus (systems), and computer program products according to implementations of the invention. It will be understood that each block of the flowchart illustrations and/or block diagrams, and combinations of blocks in the flowchart illustrations and/or block diagrams, may be implemented by computer readable program instructions.

These computer readable program instructions may be provided to a processor of a general purpose computer, special purpose computer, or other programmable data processing apparatus to produce a machine, such that the instructions, which execute via the processor of the computer or other programmable data processing apparatus, create means for implementing the functions/acts specified in the flowchart and/or block diagram block or blocks. These computer readable program instructions may also be stored in a computer readable storage medium that may direct a computer, a programmable data processing apparatus, and/or other devices to function in a particular manner, such that the computer readable storage medium having instructions stored therein includes an article of manufacture including instructions which implement aspects of the function/act specified in the flowchart and/or block diagram block or blocks.

The computer readable program instructions may also be loaded onto a computer, other programmable data processing apparatus, or other device to cause a series of operational steps to be performed on the computer, other programmable apparatus or other device to produce a computer implemented process, such that the instructions which execute on the computer, other programmable apparatus, or other device implement the functions/acts specified in the flowchart and/or block diagram block or blocks.

The flowchart and block diagrams in the figures illustrate the architecture, functionality, and operation of possible implementations of systems, methods and computer program products according to various implementations of the present disclosure. In this regard, each block in the flowchart or block diagrams may represent a module, segment, or portion of code, which includes one or more executable instructions for implementing the specified logical function(s). It should also be noted that, in some alternative implementations, the functions noted in the block may occur out of the order noted in the figures. For example, two blocks shown in succession may, in fact, be executed substantially concurrently, or the blocks may sometimes be executed in the reverse order, depending upon the functionality involved. It will also be noted that each block of the block diagrams and/or flowchart illustration, and combinations of blocks in the block diagrams and/or flowchart illustration, may be implemented by special purpose hardware-based systems that perform the specified functions or acts, or combinations of special purpose hardware and computer instructions.

The descriptions of the various implementations of the present disclosure have been presented for purposes of illustration, but are not intended to be exhaustive or limited to implementations disclosed. Many modifications and variations will be apparent to those of ordinary skill in the art without departing from the scope and spirit of the described implementations. The terminology used herein was chosen to best explain the principles of implementations, the practical application or technical improvement over technologies found in the marketplace, or to enable others of ordinary skill in the art to understand implementations disclosed herein.

## Claims

1. A method for temperature control, comprising:

   determining predicted load information of a target device based on historical operating information associated with operation of the target device, the predicted load information comprising at least a predicted load of the target device at a first time point;
   determining a first temperature indicator of a coolant predicted at the first time point based on the predicted load, historical temperature information of the coolant, and historical operating information of a coolant driving device, the coolant being configured to cool the target device, and the coolant driving device being configured to drive a flow of the coolant; and
   determining a first operating parameter of the coolant driving device at the first time point based at least on the first temperature indicator.

2. The method of claim 1, wherein the historical temperature information comprises a second temperature indicator of the coolant at a second time point, and the historical operating information comprises a second operating parameter of the coolant driving device at the second time point, the second time point being before the first time point, and determining the first temperature indicator comprises:

   obtaining a correlation for a temperature of the coolant, the correlation indicating a dependence of a temperature indicator of the coolant on an operating parameter of the coolant driving device and a load of the target device; and
   predicting the first temperature indicator according to the correlation and based on the predicted load, the second temperature indicator, and the second operating parameter.

3. The method of claim 2, wherein obtaining the correlation comprises:

determining respective historical temperature indicators of the coolant at a plurality of historical time points before the first time point based on the historical temperature information;

determining respective historical operating parameters of the coolant driving device at the plurality of historical time points based on the historical operating information; and

determining the correlation based on the respective historical temperature indicators, the respective historical operating parameters, and respective historical loads of the target device at the plurality of historical time points.

4. The method of claim 1, wherein the first temperature indicator comprises a difference between a temperature of the coolant at a first location and a temperature at a second location in a flow path.

5. The method of claim 1, wherein the predicted load information comprises respective predicted loads of the target device at a plurality of time points, the plurality of time points comprising at least the first time point and a third time point after the first time point, and determining the first operating parameter comprises:

constructing a temperature control objective, the temperature control objective being configured to at least reduce a difference between respective predicted temperature indicators at the plurality of time points and a reference temperature indicator; and

determining a parameter value of the first operating parameter according to the temperature control objective and based on the respective predicted loads, the first temperature indicator and the correlation for the temperature of the coolant, the correlation indicating a dependence of a temperature indicator of the coolant on an operating parameter of the coolant driving device and a load of the target device.

6. The method of claim 5, wherein the temperature control objective is further configured to reduce power consumption of the coolant driving device at the plurality of time points.

7. The method of claim 5, wherein determining the parameter value of the first operating parameter is further based on at least one of:

a range of values for the respective predicted temperature indicators, and

a range of values of respective operating parameters of the coolant driving device at the plurality of time points.

8. The method of claim 1, wherein the historical operating information comprises:

a load of the target device during a first historical time period before the first time point, and

an environmental factor experienced by the target device during a second historical time period before the first time point.

9. An apparatus for temperature control, comprising:

a load information determining module configured to determine predicted load information of a target device based on historical operating information associated with operation of the target device, the predicted load information comprising at least a predicted load of the target device at a first time point;

a temperature indicator determining module configured to determine a first temperature indicator of a coolant predicted at the first time point based on the predicted load, historical temperature information of the coolant, and historical operating information of a coolant driving device, the coolant being configured to cool the target device, and the coolant driving device being configured to drive a flow of the coolant; and

an operating parameter determining module configured to determine a first operating parameter of the coolant driving device at the first time point based at least on the first temperature indicator.

10. An electronic device, comprising:

at least one processing unit; and

at least one memory coupled to the at least one processing unit and storing instructions executable by the at least one processing unit, the instructions, when executed by the at least one processing unit, causing the electronic device to perform the method of any of claims 1 to 8.

11. A computer-readable storage medium having a computer program stored thereon, the computer program being executable by a processor to perform the method of any of claims 1 to 8.

FIG. 1

FIG. 2

FIG. 3

220

| 202 PREDICTED LOAD INFORMATION | 203 HISTORICAL OPERATING INFORMATION | 204 HISTORICAL TEMPERATURE INFORMATION |

410 OBJECTIVE CONSTRUCTING UNIT

401 PREDICTED TEMPERATURE INDICATOR

402 TEMPERATURE CORRELATION

403 TEMPERATURE CONTROL OBJECTIVE

420 OPTIMIZATION UNIT

205 PREDICTED OPERATING PARAMETER

FIG. 4

500

510 DETERMINE PREDICTED LOAD INFORMATION OF A TARGET DEVICE BASED ON HISTORICAL OPERATING INFORMATION ASSOCIATED WITH OPERATION OF THE TARGET DEVICE

520 DETERMINE A FIRST TEMPERATURE INDICATOR OF A COOLANT PREDICTED AT THE FIRST TIME POINT BASED ON THE PREDICTED LOAD, HISTORICAL TEMPERATURE INFORMATION OF THE COOLANT, AND HISTORICAL OPERATING INFORMATION OF A COOLANT DRIVING DEVICE

530 DETERMINE A FIRST OPERATING PARAMETER OF THE COOLANT DRIVING DEVICE AT THE FIRST POINT OF TIME BASED AT LEAST ON THE FIRST TEMPERATURE INDICATOR

FIG. 5

600 ⌐

```
┌ ─ ─ ─ ─ ─ ─ ─ ─ ─ ─ ─ ─ ┐
│              ⌐ 610      │
│   ┌──────────────────┐  │
│   │  LOAD INFORMATION │  │
│   │ DETERMINING MODULE│  │
│   └──────────────────┘  │
│              ⌐ 620      │
│   ┌──────────────────┐  │
│   │   TEMPERATURE     │  │
│   │    INDICATOR      │  │
│   │ DETERMINING MODULE│  │
│   └──────────────────┘  │
│              ⌐ 630      │
│   ┌──────────────────┐  │
│   │OPERATING PARAMETER│  │
│   │ DETERMINING MODULE│  │
│   └──────────────────┘  │
└ ─ ─ ─ ─ ─ ─ ─ ─ ─ ─ ─ ─ ┘
```

FIG. 6

700 ⌐

```
┌ ─ ─ ─ ─ ─ ─ ─ ─ ─ ─ ─ ─ ─ ─ ─ ─ ─ ─ ─ ┐
│  ┌──────────────┐         ┌──────────────┐ │
│  │PROCESSING UNIT│─710    │STORAGE DEVICE│─730│
│  └──────────────┘         └──────────────┘ │
│  ┌──────────────┐         ┌──────────────┐ │
│  │   MEMORY     │         │COMMUNICATION │─740│
│  │        ─720  │         │    UNIT      │ │
│  │725 ⌐         │         └──────────────┘ │
│  │ ┌──────────┐ │         ┌──────────────┐ │
│  │ │ PROGRAM  │ │         │ INPUT DEVICE │─750│
│  │ │ PRODUCT  │ │         └──────────────┘ │
│  │ └──────────┘ │         ┌──────────────┐ │
│  └──────────────┘         │OUTPUT DEVICE │─760│
│                           └──────────────┘ │
└ ─ ─ ─ ─ ─ ─ ─ ─ ─ ─ ─ ─ ─ ─ ─ ─ ─ ─ ─ ┘
```

FIG. 7

## INTERNATIONAL SEARCH REPORT

| International application No. |
|---|
| **PCT/CN2024/074006** |

| | |
|---|---|
| **A.** | **CLASSIFICATION OF SUBJECT MATTER** |
| | G05D23/20(2006.01)i |

According to International Patent Classification (IPC) or to both national classification and IPC

| | |
|---|---|
| **B.** | **FIELDS SEARCHED** |

Minimum documentation searched (classification system followed by classification symbols)

IPC:G05D23/-; H05K7/20; G06F

Documentation searched other than minimum documentation to the extent that such documents are included in the fields searched

Electronic data base consulted during the international search (name of data base and, where practicable, search terms used)

CNTXT, ENTXTC, VEN, ENTXT: 温度, 冷却, 降温, 制冷, 液冷, 冷却液, 预测, 预估, 负载, 功率, temperature, cooling, refregerat+, liquid, coolant, predict, load, power

| | |
|---|---|
| **C.** | **DOCUMENTS CONSIDERED TO BE RELEVANT** |

| Category* | Citation of document, with indication, where appropriate, of the relevant passages | Relevant to claim No. |
|---|---|---|
| Y | US 2011320055 A1 (YAMACHI, Y. et al.) 29 December 2011 (2011-12-29) description, paragraphs [0031]-[0151], and figures 1-15 | 1-11 |
| Y | CN 114706435 A (BEIJING SEMICONDUCTOR SPECIAL EQUIPMENT RESEARCH INSTITUTE (THE 45TH RESEARCH INSTITUTE OF CHINA ELECTRONICS TECHNOLOGY GROUP CORPORATION)) 05 July 2022 (2022-07-05) description, paragraphs [0103]-[0117], and figures 1-10 | 1-11 |
| PX | CN 116126052 A (BEIJING YOUZHUJU NETWORK TECHNOLOGY CO., LTD.) 16 May 2023 (2023-05-16) description, paragraphs [0026]-[0123], and figures 1-7 | 1-11 |
| A | US 2012158206 A1 (LONGOBARDI, G. et al.) 21 June 2012 (2012-06-21) entire document | 1-11 |
| A | CN 115562390 A (XY-HUST ADVANCED MANUFACTURING ENGINEERING RESEARCH INSTITUTE et al.) 03 January 2023 (2023-01-03) entire document | 1-11 |
| A | WO 2022028245 A1 (GREAT WALL MOTOR CO., LTD.) 10 February 2022 (2022-02-10) entire document | 1-11 |

☐ Further documents are listed in the continuation of Box C.     ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **03 May 2024** | **04 May 2024** |

| Name and mailing address of the ISA/CN | Authorized officer |
|---|---|
| **China National Intellectual Property Administration (ISA/ CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2024/074006**

| Patent document cited in search report | | | Publication date (day/month/year) | Patent family member(s) | | | Publication date (day/month/year) |
|---|---|---|---|---|---|---|---|
| US | 2011320055 | A1 | 29 December 2011 | WO | 2010106688 | A1 | 23 September 2010 |
| | | | | JPWO | 2010106688 | A1 | 20 September 2012 |
| | | | | JP | 5375948 | B2 | 25 December 2013 |
| CN | 114706435 | A | 05 July 2022 | | None | | |
| CN | 116126052 | A | 16 May 2023 | | None | | |
| US | 2012158206 | A1 | 21 June 2012 | US | 8676397 | B2 | 18 March 2014 |
| CN | 115562390 | A | 03 January 2023 | | None | | |
| WO | 2022028245 | A1 | 10 February 2022 | | None | | |

Form PCT/ISA/210 (patent family annex) (July 2022)

**REFERENCES CITED IN THE DESCRIPTION**

**Patent documents cited in the description**

- CN 202310118291